# EUROPEAN PATENT SPECIFICATION

(11) **EP 3 687 056 B1**
(45) Date of publication and mention of the grant of the patent: **10.06.2026**
(21) Application number: 19305087.9
(22) Date of filing: 23.01.2019
(51) Int. Cl.: H02N 2/18, H04L 12/28, H10N 30/30, H04W 84/18

(54) **DYNAMIC SELECTION OF A COMMAND TO BE SENT FROM MOTION SENSORS IN AN ENERGY HARVESTING DEVICE**
DYNAMISCHE AUSWAHL EINES VON BEWEGUNGSSENSOREN ZU SENDENDEN BEFEHLS IN EINER ENERGIEGEWINNUNGSVORRICHTUNG
SÉLECTION DYNAMIQUE D'UNE COMMANDE À ENVOYER À PARTIR DE CAPTEURS DE MOUVEMENTS DANS UN DISPOSITIF DE COLLECTE D'ÉNERGIE

(43) Date of publication of application: 29.07.2020
(73) Proprietor: Netatmo, 92100 Boulogne Billancourt (FR)
(72) Inventor: PAOLI, Romain, 92190 MEUDON (FR); HURABIELLE, Adèle, 92210 SAINT-CLOUD (FR); DEBARD, Marie, KIRKLAND, WA Washington 98033 (US); MATIGNON, Florent, 75015 PARIS (FR); POTTER, Frédéric, 92200 NEUILLY-SUR-SEINE (FR)
(74) Representative: Atout PI Laplace

(56) References cited:
- EP-A1- 3 155 841
- EP-B1- 3 155 841
- US-A1- 2010 090 477
- US-A1- 2014 194 062
- US-A1- 2016 374 016
- US-A1- 2017 208 890

## Description

### FIELD OF THE INVENTION

The present invention relates to the field of loT (Internet of Things) devices. More specifically, the invention relates to the improvement of ergonomics of loT devices with communication capabilities.

### BACKGROUND PRIOR ART

Most electronic products, such as remote controls, use batteries. A battery provides the product with a flexible access to electrical energy, whenever it needs it. Nevertheless, batteries are finite supply of power, and the user has to charge or change the battery from time to time.

Energy harvesting technologies, such as piezoelectric material, have supplied new generations of products with a small amount of energy that recharges automatically during the life and use of the product.

Energy harvesting technology may harvest electrical energy from an ordinary gesture done by a user. For example, upon the user pushing a button, the energy harvester stores a small amount of electrical energy. This small amount of electrical energy - if properly used - can allow operations such as computations, operating sensors, or sending radio signals. Moreover, energy harvesting devices, by not requiring to be equipped with batteries, do not cause to a user the burden of worrying about the charge of the device.

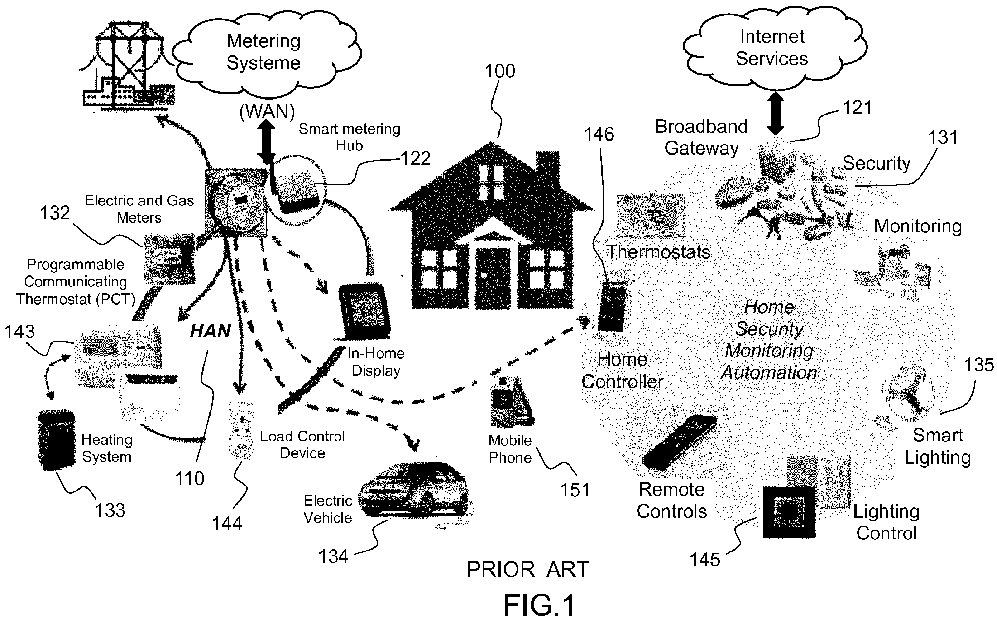

Figure 1 represents a number of devices with applications in a smart home environment.

The description of the different systems illustrated in figure 1 will allow a better understanding of the use cases of the instant invention. Nevertheless, these use cases should not be construed as limitative but only illustrative of the field of application of the invention.

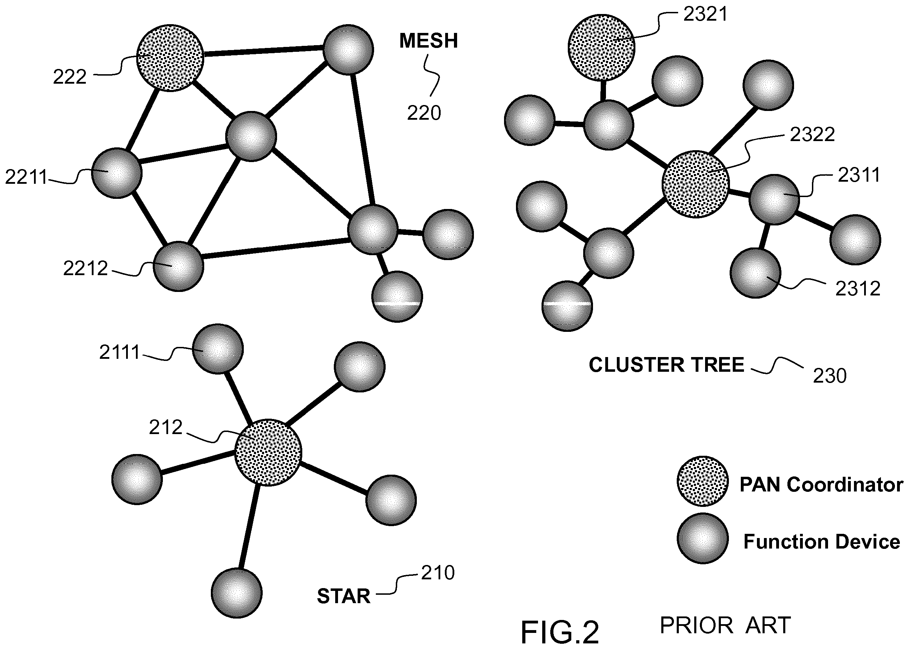

The smart building 100 represented in figure 1 has one or more Local Area Networks or Home Area Networks (LAN or HAN, 110). LANs may use various types of transmission layers, such as: Ethernet cable, optical fiber, Power Line Carrier (PLC), wireless transmission. Different protocols may be used. In the case of a wireless transmission media, Wi-Fi or Zigbee are among the most popular. It is likely that 5G will also be used for HAN when it becomes available. Zigbee HANs will be described in relation to figure 2.

In a building, there may be a single LAN or a plurality of LANs. The option may depend on the obligation to use more than one gateway to communicate with the outside world. For instance, there may be a first gateway 121 to access Internet services and there may be a second gateway 122 to access metering systems 132.

A security monitoring application 131 may be deployed in and/or around the building 100. It may consist of a number of sensors such as: visible light or IR cameras; radars or LIDARS; sound detectors, presence sensors; proximity sensors; etc... Some sensors may be located inside the building. Other sensors may be located outside the building.

The heating system 133 of the building 100 may be a programmable heating system controllable locally by a Programmable Communicating Thermostat (PCT, 143). The PCT may have one or more temperature setpoints. The temperature setpoints may be entered manually in the PCT. A plurality of temperature setpoints may be programmed locally on the PCT based on a daily timeline (early night/mid night/late night/early morning/midday/late day temperature setpoints, by way of non limitative examples). The PCT being connected to a HAN, it may also be programmed remotely, for instance using an application installed on and/or accessible from a mobile phone 151. In some embodiments of a heating system, thermostatic radiators may be installed on some or all of the radiators of the heating system and their temperature setpoints may also be controlled either locally or remotely. Also, a refrigerating equipment may be controlled locally or remotely in a way that is similar to the way a heating system is controlled.

An electric vehicle 134 may be reloaded using a Vehicle Charging Device (VCD) in a garage of the building 100. The VCD may be controlled locally using a Load Control Device 144. The charge dispensed by the VCD may also be controlled remotely using an application.

A Smart Lighting System (SLS, 135) may be also installed in the building 100. A SLS may consist of a number of smart light bulbs or of a number of smart plugs where lamps may be plugged. The smart light bulbs and smart plugs are equipped with control boards or Systems on Chip (SoC). A lighting control 145 will then allow controlling the current in the smart light bulb or plug to be switched from the OFF state to the ON state and vice-versa or to be varied to reduce/increase the brightness of the light. There may be one remote control per room. In some instances, a remote control may be combined with another switch to form a two-way switch. But there may be also a plurality of lighting controls in a room or a central lighting control from where a number of rooms may be controlled. It is to be noted that equipments that are not lamps may be plugged in a smart plug, such as an electric heating equipment, an electric cooking equipment, or any other kind of electric equipment whose functioning can be commanded both in a binary manner or in a continuous manner.

Other types of systems, not displayed in the figure, may also be included in a HAN. For instance, blinds/shutters may be equipped with electric motors and controlled and actuated either locally (room by room or centrally) or remotely. TV sets may be equipped to be programmable remotely, for instance to record programs for later playback. A number of sensors may be placed inside or outside the building to monitor the temperature, the quality of ambient air, the intensity of wind, the humidity, the amount of rain, etc. The measurements of the sensors may be sent to a server of a service provider for processing, consolidation and redistribution to the service subscribers. The measurements may also be sent only to the owner or tenant of the building, partially (privacy issues) or in total.

The controllers of the various smart control applications or subsystems running in the building 100 may be centralized at a central home controller 146. From the central home controller, it may be possible to control all applications, or only some of them. In some embodiments, the central home controller may be accessible remotely.

Some or all of the devices or equipments of the different subsystems 131, 132, 133, 134, 135 are connected to a LAN/HAN that is an RF network. Other subsystems not displayed in the figure may also be connected to the HAN. Also, the controlling devices, 143, 144, 145 of some of the subsystems, and of subsystems not displayed on the figure should be connected to the HAN in a manner now commented upon in relation to figure 2.

Many of the devices discussed with reference to figures 1 and 2, for example the remote control, may be devices with energy harvesting capabilities.

Generally, a portable device with energy harvesting capability has a defined purpose. For example, a remote light switch can send radio signals to switch ON or OFF a light, when the user presses a button; a remote control for controlling a shutter can send radio signals to open or close the shutter, when the user presses a button. These actions define the daily operations of a device.

On the contrary, some operations are used for specific purposes, in specific contexts, beyond daily operations of the product. A typical purpose beyond daily operations is commissioning. Commissioning is the act of creating communication and relationship between several devices, in a defined way (for example, device A communicates with and controls device B but not device C) and secured way (for example, another device C cannot impersonate device A to control device B).

Some portable devices thus need, upon an input of a user, to send radio signals that are representative either of daily use, or specific operations. A simple and intuitive way of selecting the relevant signals is to provide the device with at least one additional button that allows a user defining if the device shall send signals representative of the daily use, or specific operations. However, if the device is an energy harvesting device, this also cancels one of the advantages of the energy harvesting device without battery, which is that an energy harvesting device is simpler for a user to use. Indeed, this requires using multiple buttons during energy harvesting, and performing at the same time gestures allowing energy harvesting, and multiple buttons pressed in a defined order. This solution is not easy for a user to use.

Some devices are also able to select different commands to be sent, based on gestures of the user. However, such devices usually rely on complex gesture recognition that requires activating a motion sensor for a significant amount of time, and using a processor to perform complex computations. Therefore, such devices consume an important amount of energy which is not compatible with energy harvesting. Moreover, in such cases energy harvesting necessarily needs to be performed before the motion that allows detecting the context, which is complex and long. This therefore introduces a latency between the moment the user wishes to send a command, and the moment the command is actually transmitted.

The American patent application published under number US 2017/208890 discloses a device that aims at analyzing the steps of a user. To do so, it comprises, in a shoe sole, a piezo element that produces energy when the user walks and generates bending on the piezo element. However it aims at sending a unique kind of frames that are representative of the steps of the user.

There is therefore the need for a portable device that is able to send radio signals representative either of a daily use operation, or a specific operation, upon the same input of the user, using gesture compatible with energy harvester amounts.

More generally, there is the need for a portable device without battery which is configured to send at least a first and/or a second frame over a network upon an action of a user, the decision to send the first or second frame being performed in an intuitive way for the user.

### SUMMARY OF THE INVENTION

To this effect, the invention discloses a device as defined according to the appended independent claim 1.

Advantageously, the energy harvester is adapted to harvest energy from an action of a user.

Advantageously, the device comprises a button, wherein the energy harvester is activated each time the user presses or depresses the button.

Advantageously, the device is a remote control, and the possible data frames are commands to be sent to said at least one further device.

Advantageously, the device is a portable light switch, and the button is a light switch button having two positions.

Advantageously, said at least one further device comprises two or more light switches; the set of possible data frames comprises a frame to associate the portable light switch with a set light switch, a frame to instruct a set light switch with which the portable light switch is associated to switch ON the light, and a frame to instruct a set light switch with which the portable light switch is associated to switch OFF the light.

Advantageously, said one or more sensors comprise one or more motion sensors.

Advantageously, the device is configured to use said one or more energy amounts to activate said one or more attitude or motion sensors to obtain signals representative of an instantaneous attitude of the device.

Advantageously, when the user presses or depresses the button, the device is configured to use said one or more energy amounts to: activate the one or more attitude or motion sensors (530), in order to produce signals representative of an instantaneous value of an attitude parameter of the device; activate the digital circuitry to select the data frame to be sent from one of: a comparison of the current value and a latest stored value of said attitude parameter of the device, or a comparison between said signals and latest stored signals representative of said instantaneous value of the attitude parameter; send said data frame; store said current value of the attitude parameter of the device, to be used as the latest stored value of said attitude parameter, or store said signals, to be used as the latest stored signals.

In a number of cases, motion sensor signals are representative of an attitude of the device. For example, accelerometer signals that sense gravity acceleration are representative of the orientation of the device with respect to Earth. In order to choose the data frame to send, it is thus either possible to calculate the values of the attitude parameters from the signals (for example, calculating the orientation of the device from the accelerometer signals), then compare the values of attitude parameters (for example values of orientation of the device) between two activations of the sensors, or compare directly the signals between two activations of the sensors (for example, comparing the elements of acceleration vectors representative of vertical acceleration between two activations of an accelerometer sensor).

Advantageously, said one or more attitude or motion sensors comprise an accelerometer, and said signals are accelerometer signals; said attitude parameter is an orientation of the device; the digital circuitry is configured to select a first data frame when: an absolute value of a difference between the instantaneous and latest stored values of orientation of the device, or an absolute value of a difference between the signals and latest stored values of the signals representative of said instantaneous value of the attitude parameter; is below a predefined threshold; the digital circuitry is configured to select a second data frame otherwise.

An absolute value of the difference is a good candidate for allowing the comparison. For example, if accelerometer measurements are used to determine the orientation with respect to Earth, it is either possible to calculate an orientation with respect to Earth at each accelerometer activation, then perform an absolute difference of the orientation between the two activations, or to calculate an absolute difference of an element of two successive acceleration vectors representative of vertical acceleration.

Advantageously, the orientation is an orientation of an axis in a transverse plan of the device.

Advantageously, said attitude parameter is an orientation of the device; the digital circuitry is configured to select the first data frame when the instantaneous value of the orientation belongs to a set of orientations, and the second data frame otherwise.

Advantageously, when the user presses or depresses the button a first time, the energy harvester harvests a first energy amount to: activate the one or more attitude or motion sensors, in order to produce signals representative of a quantity of motion of the device until the user presses or depresses the button a second time; when the user presses or depresses the button the second time, the energy harvester harvests a second energy amount to: activate the digital circuitry to select the data frame to be sent from said quantity of motion of the device; send said data frame.

The invention also discloses a method as defined according to the appended independent claim 14.

The invention also discloses a computer program product as defined according to the appended independent claim 15.

The disclosure allows the selection of a data frame to be sent, among frames that belong either to the daily use of a product, or frames that are intended for a specific purpose.

A device of the invention uses energy that is harvested when needed. Therefore, the user does not need to worry about the energy usage of the device, or check if the device is charged.

According to the disclosure in certain aspects, a device requires neither a battery nor an additional button click from a user to select a frame. A device of the invention can be as light and small as possible. This increases the simplicity of use of the device.

According to the disclosure in certain aspects, a device can perform a frame selection based on precise orientations of the device, only using energy provided by energy harvesting. These reliable values of orientation allow defining rules of selection of the frame to be sent based on motion of the user that are intuitive for the user.

According to the disclosure in certain aspects, a device can detect if it is set to a wall, and avoid a false detection of gesture to select specific operations accordingly.

According to the disclosure in certain aspects, a device can detect if it is set to a door, and avoid a false detection of gesture to select specific operations accordingly.

The disclosure in certain aspects allows selecting a frame to be sent only using the instantaneous orientation of the device.

The disclosure in certain aspects allows selecting a frame to be sent using a comparison between the instantaneous orientation, and a previously stored orientation of the device.

The disclosure in certain aspects allows selecting a data frame to be sent depending on the quantity of motion imparted by the user, which is a very intuitive means of selecting a data frame to send.

### BRIEF DESCRIPTION OF THE DRAWINGS

The invention will be better understood and its various features and advantages will emerge from the following description of a number of exemplary embodiments and its appended figures in which:
- figure 1 represents a number of devices with applications in a smart home environment;
- figure 2 represents a topology of a Zigbee network;
- figure 3 displays a network of devices comprising a device in an embodiment of the invention;
- figure 4 displays an example of energy harvesting in an embodiment of the invention;
- figure 5 displays an architecture of a device in an embodiment of the invention;
- figure 6 displays two mechanical constraints allowing a selection of a frame to be sent by a device according to the invention;
- figure 7 displays an example of selection, in an embodiment of the invention, of a data frame to be sent based on the orientation of the device;
- figure 8 displays an example of selection, in an embodiment of the invention, of a data frame to be sent based on the quantity of motion of the device; and
- figures 9a, 9b and 9c display an example of selection, in an embodiment of the invention, of a data frame based on a button on the back of the device, indicating if the device is placed on a flat surface or is in free space ;
- figure 10 displays a method in a number of embodiments of the invention.

### DETAILED DESCRIPTION OF THE INVENTION

Figure 2 represents a topology of a Zigbee network.

The LAN/HAN can be a Zigbee network. It is also possible to use other HANs or LANs (also sometimes called Personal Area Networks or PANs). For instance, the invention may also be used with a Wi-Fi network.

Zigbee networks are the subject of a specification developed by the Zigbee alliance that comprises a number of device manufacturers. The Zigbee network specification is an IEEE standard (IEEE 802.15.4). It is applicable to Wireless Personal Area Networks (WPANs). It encompasses short-range Line of Sight (LOS, 1-10 m), low-power devices. Zigbee networks are well suited for communicating devices at intermittent, low data rate that need to have a long battery life and a secure communication protocol. Zigbee communications use a 20 to 250 kb/s data rate and an encryption 128-bits symmetric key.

The RF frequencies used for the Zigbee communications are some of the Industrial Scientific and Medical (ISM) frequency bands that have the advantage of being loosely regulated. The 2,4GHz frequency band is available for these applications in most jurisdictions. Alternatively or in addition, the 784 MHz band is available in China, the 868 MHz band is available in Europe and the 915 MHz band is available in the USA and Australia.

The objects connected to the network are designated as Zigbee Device Objects (ZDOs). They may be sensors, actuators, input devices or any type of devices that may be controlled or actuated, such as the ZDOs of the invention. ZDOs will then comprise a device control unit or Smart Electric Controller (or SEC) comprising a Zigbee transmit/receive (T/R) unit comprising or associated with a number of circuits like a processor, a memory, a power control circuit connected on a bus. The SEC may be embodied in an electronic board or in a System on Chip (SoC) circuit. Examples of such SoCs (including or not additional circuitry of the type mentioned above) comprise:
- The MRF24J40 from MICROCHIP^{™};
- The CC2650 from Texas Instruments^{™};
- The EM358x and EFR32MGxxxxx from SiliconLabs^{™};
- The ATSAMR21 from MICROCHIP^{™}.
Other devices may of course be used without departing from the scope of the invention and it is likely that, with the advancement of communication technologies and devices, other devices and standards may appear in the future.

Typically, three architectures of a PAN/Zigbee network may be envisaged: a star architecture 210, where all ZDOs 2111 communicate only with a PAN coordinator 212; a mesh architecture 220, where all ZDOs 2211, 2212 communicate with a PAN coordinator 222, either directly or indirectly, as well as with the other ZDOs of the network 2212, 2211; a cluster tree architecture 230, that may have more than one PAN coordinator 2321, 2322, to and from which the ZDOs 2311, 2312 may communicate as well as to and from other ZDOs, 2312, 2311.

In the mesh architecture and in the cluster tree architecture, the communication range may be extended by device-to-device relay of messages, possibly in non-LOS.

The PAN/Zigbee coordinator 212, 222, 2321, 2322 is a specific network node that is configured to maintain/control a list of the addresses/identifiers of the network nodes. The PAN/Zigbee coordinator may be coupled to a gateway to another PAN, another LAN, a WAN or to Internet services to provide extended communication capabilities, symmetric or one-way only.

The Zigbee protocol layer supports two types of services:
- The cluster service (e.g key-value pair service or KVP) is meant for configuration purposes; it enables description, request and modification of object attributes through a simple interface based on getting/setting values as well as event primitives, some allowing a request for a response. Configuration uses compressed or full XML.
- The Message service is designed to offer a general approach to information treatment, avoiding the necessity to adapt application protocols and potential overhead incurred by KVP. It allows arbitrary payloads to be transmitted over APS (APplication Sublayer) frames.

The cluster and message services that can be used, and more generally the messages that may be exchanged in a Zigbee network are defined by profiles. The Zigbee profiles are defined by a unique ID. Zigbee supports both public profiles (for example Industrial Plant Monitoring (IPM) profiles, or Home Automation (HA) profiles that allow interoperability between devices from different manufacturers), and Manufacturer Specific Profiles (MSP) that are more flexible, may provide extended functionalities and be updated easily, but do not allow interoperability with all Zigbee-compliant devices.

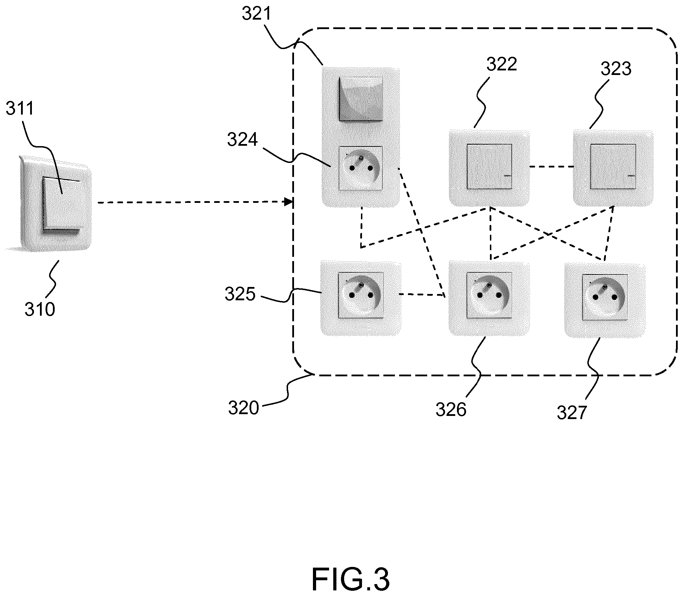

Figure 3 displays a network of devices comprising a device in an embodiment of the invention.

The portable light switch 310 equipped with a button 311 can connect to the network 320 comprising three light switches 321, 322, 323, and four electrical outlets 324, 325, 326 and 327. The portable light switch can either, when a user presses the button 311:
- perform a commissioning to the network 320. Commissionning consists in being able to comunicate within the network and pair with specific devices of this network. This action needs to be performed once (or at least once each time the user wishes to commission to a different network) and is therefore a specific operation;
- send a signal to switch on or off one or more of the four electrical outlets 324, 325, 326 and 327. This action is performed on a daily basis, and is therefore a daily operation.

As will be explained herein below, the invention allows the device 310 to determine, upon a single action of the user, radio signals to be sent. Although the invention is especially suitable to disambiguate between operations that occur on a daily basis, and specific operations, the invention is not restricted to this use case. Similarly, the invention is not restricted to a light switch, and could be applied to any kind of device for which different radio signals may be sent, upon the same input of the user.

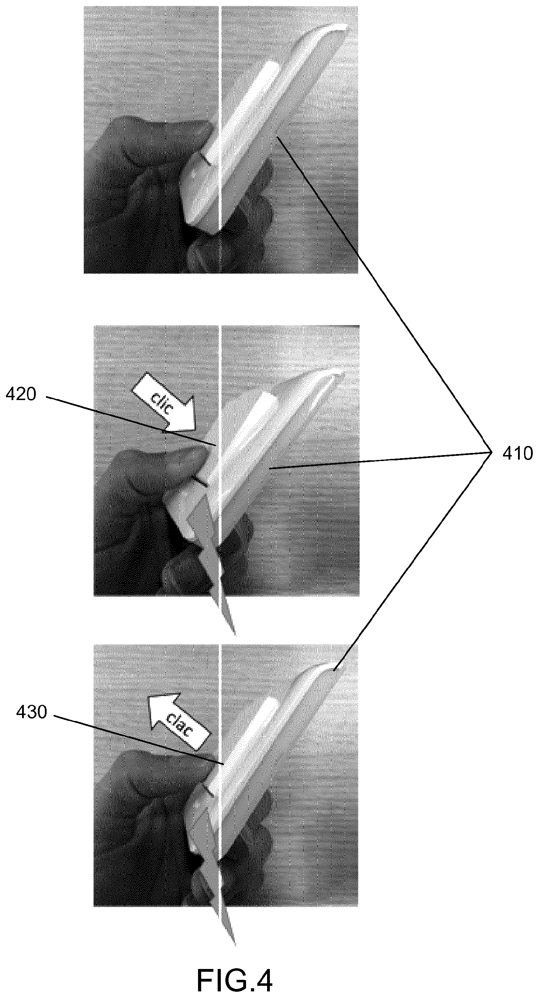

Figure 4 displays an example of energy harvesting in an embodiment of the invention.

The energy harvesting device 410 is a light switch, and may be for example the light switch 310. The light switch is equipped with a piezoelectric material that harvests energy when the user presses the button 420. In a number of embodiments of the invention, the piezoelectric material also harvests energy when the user depresses the button 430.

However, the invention is not restricted to this example. For example, the energy harvesting device may be any kind of device configured to send a plurality of different signals. In addition, the energy harvesting can be performed in many different ways: for example, it may be harvested when the user performs a circular movement. Examples of energy harvesting from rotational movements are provided by Häggström, F., Gustafsson, J., & Delsing, J. (2014, September). Energy harvesting technologies for wireless sensors in rotating environments. In Emerging Technology and Factory Automation (ETFA), 2014 IEEE (pp. 1-4). IEEE.

More generally, a wide range of different energy harvesting components allow converting mechanical energy supplied by a user into electrical energy (for example, the piezoelectric material converts mechanical energy of the user pressing the button into electric energy). In such a case, the energy is harvested from an action of the user.

In other cases, the energy is also harvested upon an action of the user, but the energy harvesting consists in converting the energy from a source which is not the mechanical energy of the motions of the user. For example, energy can be harvested using induction, NFC (Near Field Communication) or micro photovoltaic panels. In each case, the energy may be harvested upon an action of the user: for example, when the user puts the device near an induction field, a very small amount of energy is harvested; in the case of photovoltaic panels, the action of the user of putting the device under sunlight will result in the lighting of the photovoltaic material, hence creating harvested energy. The energy is usually not stored and needs to be used in a very short time.

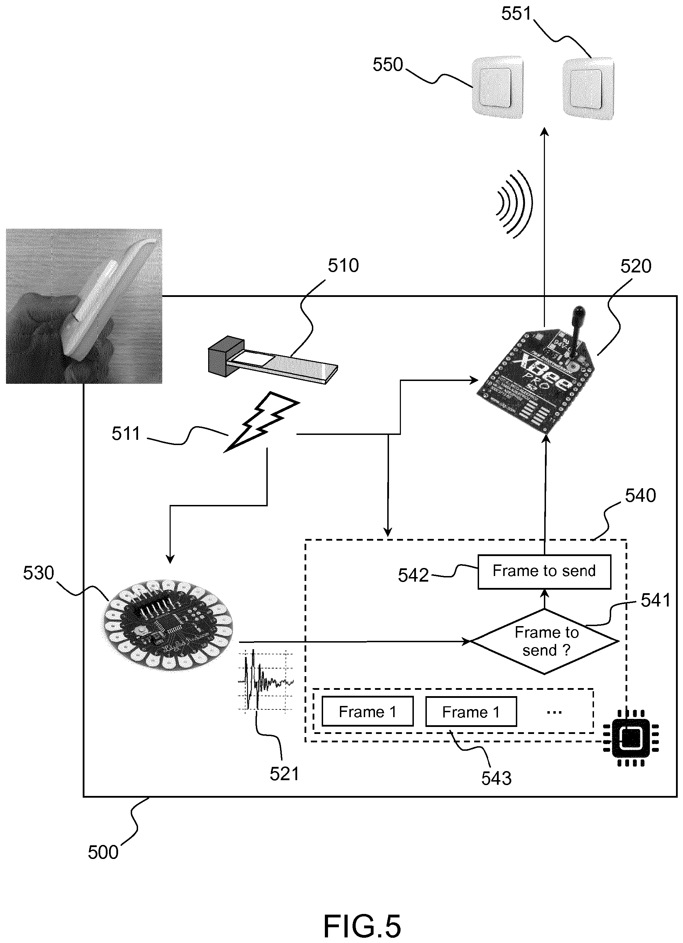

Figure 5 displays an architecture of a device in an embodiment of the invention.

The device 500 may be any kind of remote control that has energy harvesting capabilities, and that is able to send different radio signals corresponding to different uses. For example, the device 500 may be a remote light switch such as the remote light switch 310 or 410 that is able to send radio frames either for commissioning a radio network, or to send commands to switch ON/switch OFF a light. Similarly, the device 500 may also be another remote controller such as the PCT 143, the Load Control Device 144 or the lighting control 145. However, the invention is not restricted to these examples. For example, the invention is applicable to many kinds of remote controls. More generally, the invention is applicable to any kind of device that is able to harvest energy and to select a data frame to be sent among a plurality of possible data frames.

To this effect, the device 500 comprises an energy harvester 510 adapted to harvest energy upon one or more actions of a user.

In figure 5, the energy harvester is represented as a piezoelectrical material that harvests energy when the user presses and/or depresses a button. However, the invention is not restricted to this example.

As already discussed with reference to figure 4, the energy harvester 510 may be adapted to harvest energy from one or more actions of the user (i.e by converting mechanical energy provided by the user into a small amount of electrical energy): this is for example the case of piezoelectrical material, or an energy harvester that converts energy from a rotation of the device imparted by the user. The energy harvester may also be an energy harvester that is configured to harvest energy upon an action of the user, but without converting energy from motions of the user. This is for example the case for energy harvesters that rely on an induction loop: when the user puts the device 500 near the induction loop, energy will be harvested, but without converting energy of the motions of the user into electrical energy.

The device 500 further comprises a communication capability 520 adapted to communicate with at least one further device 550, 551.

The at least one further device 550, 551 is a device to which the device 500 may send data frames. For example, it may be a device that is controlled by the device 500, when the device 500 is a remote control. For example, if the device 500 is a portable light switch, the at least one further device 550, 551 may be a light switch that is controlled remotely by the device 500.

The communication capability 520 may be any kind of communication capability suitable for communicating with the at least one further device. Figure 5 displays a communication capability 520 that is a radio antenna. Such a radio antenna may be configured to send to the at least one further device 550, 551, either directly or indirectly, data frames using a radio protocol, such as the Bluetooth^{™}, Wi-Fi^{™} or Zigbee^{™} protocol. Any suitable radio protocol can be used. However, the invention is not restricted to this example: the communication capability 520 may be any kind of communication capability configured to send data frames to the at least one further device 550, 551, for example a wired or wireless communication capability.

The device 500 is configured to send to the at least one further device data frames that belong to a set 543 of data frames. According to various embodiments of the invention, the set 543 of data frames may comprise different frames. For example, the data frames 543 may comprise a frame that belongs to the daily use of the device, and frames to be used for a specific purpose. For example, if the device 500 is a remote light switch, one of the frames of the set 543 may be a frame to switch ON/OFF a light (frame representative of the daily use of the product), and one or more frames of the set 543 may be frames to perform a commissioning of a network, wherein light to be controlled remotely are present (specific purpose). As will be explained in further details below, the invention allows the device 500 to select a frame to be sent and, for example, select a frame that belongs either to the daily use of the device or to a specific purpose.

More generally, the device 500 can be any remote control that is able to send either a frame to perform a "daily operations" command (e.g heating if the remote control controls a heater, opening/closing a shutter, etc...), or a specific command, such as a command for commissioning a network, or more generally associating the remote control to a device.

The invention may also be used to perform other kinds of choice of frames. For example, the invention may allow to send either a frame to switch ON light or a frame to switch OFF light using a remote control with a single button.

The device 500 further comprises one or more sensors 530. The one or more sensors 530 are used to obtain signals representative of the position, attitude or motion of the device 500. A position of the device 500 may be defined as an absolute position, a position relative to its environment, or a custom position. For example, a position may be defined as "on a wall", "on a door", "near a window", "in a kitchen", etc... The attitude of the device comprises the absolute or relative orientation of the device.

According to various embodiments of the invention, a number of different sensors may be used. For example, one or more of the sensors below may be used, for example:
- a light sensor: a number of different rules can be defined for identifying the postion of a device according to the output of a light sensor. For example, if the output of the light sensor indicates that an important amount of light is detected, the device can be expected to be in a position "near a window". Another possible rule may consist in identifying that the device is upon a wall, if the light sensor senses a very limited amount of light, i.e is obstructed from light. More generally, any rule that identifies a position of the device based on the perceived luminosity may be used;
- a hygrometer: if the output of the hygrometer indicates that the device is in a very wet environment, the device can be expected to be in a position "in a bathroom".

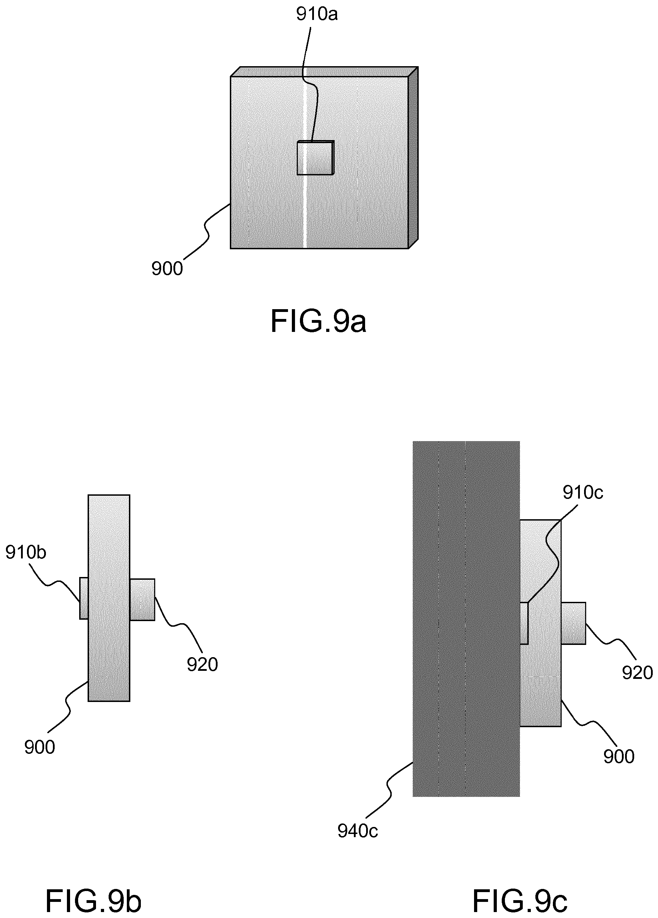

In a number of embodiments of the invention, a button can be used as a sensor, if it is carefully placed within the device 500. For example, a push button can be placed on the back of the device 500, in order to extrude from the back of the device 500 only when it is depressed. An example of such button is provided with reference to the figures 9a to 9c. Therefore, when the user sets the device 500 on a flat wall or a door, the button is automatically pressed. Therefore, the signals indicating that the button is pressed can be interpreted as signals indicating that the device 500 is set on a wall or a door. Conversely, a button can be placed on the back of the device 500, so that it is necessarily pinched when and only when the user holds the device. Thus, a signal indicating that the button is pinched can be interpreted as a signal indicating that the button is located "in the hand of the user". In all these examples, the sensors provide signals indicating the position of the device, without the user having to perform an explicit button press or action.

In a number of embodiments of the invention, some or all of the one or more sensors 530 are attitude or motion sensors. Such attitude or motion sensor(s) may be any kind of sensor that allows generating signals representative of the attitude or motion of the device 500. For example the one or more attitude or motion sensors may comprise one or more of an accelerometer, a gyro, a magnetometer etc...

More generally, any sensor providing signals providing information relative to the position, attitude or motion of the device 500, without the user having to consciously and explicitly perform a button press can be used by a device 500 according to the invention. As will be explained in more details hereinafter, the analysis of these signals allows selecting a frame to be sent without the user worrying about performing a button press.

The device 500 may either comprise one or a plurality of sensors. When the device 500 comprises a plurality of attitude or motion sensors, they may be used either separately, or in combination, using data fusion.

The device 500 further comprises a digital circuitry 540.

The digital circuitry 540 may be any suitable type of digital circuitry. The digital circuitry 540 may be a processor such as a microcontroller unit, or another type of processor, such as a microprocessor for example. The digital circuitry may also be an integrated circuit (IC), such as an ASIC (Application-Specific Integrated Circuit) or a FPGA (Field-Programmable Gate Array) for example.

The device 500 is configured, when one or more energy amounts 511 are harvested upon one or more actions of the user, to use said one or more energy amounts 511 for a plurality of successive tasks.

The device is first configured to use said one or more energy amounts 511 to activate the one or more sensors 530, to produce signals representative of the position, attitude or motion of the device. The type of signals produced are dependent upon the type of sensor. For example, if the one or more sensors 530 comprise an accelerometer, the signals may be signals representative of the acceleration of the device.

In a number of embodiments of the invention, some or all of the sensors are motions or attitude sensors, and the device is configured to use said one or more energy amounts to activate one or more attitude sensors to obtain signals representative of an instantaneous attitude of the device.

For example, if the one or more sensors comprise an accelerometer, an energy amount can be used to activate the accelerometer, and obtain an instantaneous measurement of acceleration. This measurement can be used to determine the gravity component of acceleration, and deduce the orientation of the device 500. Therefore, this allows obtaining a reliable value of the orientation of the device using a very low amount of energy, which is well suited to be used with a low amount of energy provided by the energy harvesting.

As will be exemplified below, these reliable values of orientation allow defining rules of selection of the frame to be sent based on motion of the device that are intuitive for the user.

If the one or more sensors comprise a button, the energy amount can be used to activate the button, and obtain a signal indicating if the button is pressed or depressed. If the one or more sensors comprise a light sensor, the energy amount can be used to activate the light sensor to obtain a measurement of the intensity of light. If the one or more sensors comprise an accelerometer, the energy amount can be used to activate the accelerometer. In a number of embodiments of the invention, the activation can be performed by simply powering the sensors.

The device 500 is further configured to use said one or more energy amounts 511 to activate the digital circuitry 540 to select 541, based at least on said signals, a data frame to be sent 542 among the set of possible data frames 543.

Therefore, the frame 542 to be sent is selected solely based on the position, motion or attitude of the device 500. The frame can thus be selected without needing an additional input from the user, such as an explicit button press by the user. Furthermore, all the energy needs of the device 500 are met using energy harvesting. Therefore, the device 500 does not need to comprise a battery. Therefore, the device can be as light and small as possible. This improves the ergonomics of the device 500.

In a number of embodiments of the invention, the one or more energy amounts 521 to activate one or more attitude or motion sensors among the sensors 530, in order to produce signals representative of an instantaneous value of an attitude parameter of the device; activate the digital circuitry 540 to select the data frame to be sent from a comparison of the current value and a latest stored value of said attitude parameter of the device; store current value of the attitude parameter of the device, to be used as the latest stored value.

Therefore, this allows, each time a new energy amount is harvested, to determine an instantaneous value of an attitude parameter of the device (for example its orientation), determine the frame to be sent based on the comparison with the latest stored value of the attitude parameter, and store the instantaneous value as the latest stored parameter, in order to be able to perform the comparison successfully at the next iteration.lt is therefore possible, each time the energy is harvested (for example, each time a user presses a button), to determine a frame to be sent based on a comparison between the instantaneous value of the attitude parameter and the value at the previous energy harvesting. For example, if the energy is harvested when a user presses a button, and the attitude parameter is an orientation of the device, this allows determining the frame to be sent based on the comparison between successive values of orientation of the device, the values being recorded each time the user presses and/or depresses a button. As will be exemplified below, this allows defining intuitive rules for the user to select the frame to be sent.

As a variant, it is possible to compare and store signals directly. For example, if the signals are signals from an accelerometer, it is possible to store and compare directly the signals from the accelerometer, rather than storing and comparing orientations deduced therefrom.

In a number of embodiments of the intervention, the set of frames comprises at least two frames, and the one or more attitude or motion sensors 530 comprise an accelerometer that generates accelerometer signals representative of an orientation of the device.

A first frame can be selected, if an absolute value of the difference between two successive values of orientation, or the absolute value of the difference between two successive acceleration signals, is below a threshold, and a second frame otherwise. Stated otherwise, the first frame is selected if, between two successive iterations (for example, between two button presses if the energy is harvested when the user presses a button), there were a small variation of orientation; the second frame is selected if, between two successive iterations, a larger variation of orientation occurred. Typically, the first frame can be a frame that belongs to daily operations, that are selected and sent most often, and the second frame can be a frame that belongs to specific operations, and are sent less often.

As noted above, the determination whether the orientation of the device has changed can be performed either using the values of orientation itself, or the acceleration signals directly.

Generally, the determination of the frame to be sent based on a simple comparison of successive values of orientations, or successive acceleration signals, can be performed using very simple calculations. Therefore, the frame can be selected by the digital circuitry with a very low power consumption. Therefore, the digital circuitry can be run using a small energy amount provided by energy harvesting to select the relevant frame.

This also allows, if the predefined threshold is set to a value representative to a near absence of movement, to detect if the device 500 is set. Indeed, some remote controls, for example remote lighting controls, may be set on any wall once the user has commissioned the network, and the device 500 is paired with at least one light to switch ON/OFF. Therefore, if the device is not set on a wall, the second data frame is sent, that may for example be used for commissioning. Once the commissioning is performed, the user wishes to set the remote light switch on the wall. Then the remote light switch hardly moves between successive button presses, and, when the user presses the button, a first frame is selected, to switch the light ON or OFF.

In a number of embodiments of the invention, the acceleration signals and/or orientation are processed around the three axes.

In a number of embodiments of the invention, the acceleration signals and/or orientation are processed around a single axis, for example the transverse axis. Therefore, the second frame is selected only if there is a significant difference of orientation around the single axis, independently of the differences of orientations around the other axes. This allows for example sending the first frame if the device 500 is on a wall or a door: if it is placed on a door, there is no change in the vertical orientation of the device when the door is opened or closed. Therefore, if the device is set either on a wall or a door, the first frame will be selected, for example to switch a light ON or OFF; otherwise, if the device is not set, the device will select a second frame, for example a frame for commissioning a network, and associate the remote control to a light to switch ON or OFF. Similarly, the selection of the frame to be sent may be performed using acceleration signals on two out of the three axes.

In a number of embodiments of the invention, upon each energy harvesting, the energy amount is used to activate an accelerometer, and determine, based on acceleration signals, an instantaneous orientation of the device. In a number of embodiments of the invention, the digital circuitry is configured to select a first data frame, or a second data frame directly based on the orientation of the device. For example, the first data frame can be selected if the instantaneous orientation of the device belongs to a set of orientations, and the second data frame otherwise.

The set of orientation can be defined to correspond to a vertical orientation higher than a predefined threshold. For example, the first frame can be selected if the device 500 is oriented downwards, and the second frame if the device 500 is oriented upwards (in this example, the predefined threshold is a vertical orientation of 0° corresponding to the device being horizontal). Naturally, other thresholds can be defined.

This solution provides the advantage of allowing a direct selection of the frame to be sent using a single energy harvesting (for example a single button push). In addition, the thresholds and frames to select can be defined in order to provide an intuitive behavior for the user. For example, a user naturally holds a remote control upwards. Therefore, an upwards orientation may correspond to a frame representative of daily use (for example switching a light ON or OFF), while a downwards orientation, which is less natural for a user, may correspond to a frame representative of a specific operation (for example commissioning a network).

This therefore allows a fast and intuitive means of selecting the frame for the user to send.

Although this principle is exemplified with a selection of two different frames depending on a vertical orientation of the device, different rules of selection can be defined. For example, more than three different frames may be selected based on the vertical orientation of the device: for example, a first frame when the device is oriented upwards, a second frame when the device is oriented near the horizontal, and a third frame when the device is oriented downwards.

The frame sent may also depend upon an input of the user, if a plurality of inputs are available. For example, a light switch may comprise a double switch button with an ON and a OFF position: in an embodiment of the invention, if the device is oriented downwards, a "switch ON" or "switch OFF" frame can be sent depending on the button position pressed by the user; if the device is oriented downwards, a commissioning frame in selected.

The orientation may also allow performing a selection between two frames representing daily use actions. For example, if the device 500 is a portable light switch comprising a single button, a "switch ON" frame may be sent if the button is pressed, while the device is oriented upwards, and a "switch OFF" frame if the device is oriented downwards, when the same button is pressed.

Another option for selecting a data frame to be sent is to calculate a quantity of motion of the device 500 when the user presses a button. This can be for example performed in the following way:
- when the user presses or depresses the button a first time, the energy harvester 510 harvests a first energy amount to:
   o activate the one or more attitude or motion sensors 530, in order to produce signals representative of a quantity of motion of the device until the user presses or depresses the button a second time;
- when the user presses or depresses the button the second time, the energy harvester harvests a second energy amount to:
   o activate the digital circuitry to select the data frame to be sent from said quantity of motion of the device.

Thus, the data frame is selected based on the quantity of motion imparted to the device, during the button press. The digital circuitry can be configured to select the data frame to be sent in different ways. For example, a first data frame can be selected if the quantity of motion is below a predefined threshold, and the second data frame otherwise.

This allows selecting a data frame to be sent depending on the quantity of motion imparted by the user, which is a very intuitive means of selection for a user.

For example, a data frame representative of "daily use" (for example, switching ON/OFF a light) can be selected if the quantity of motion is low, and a data frame for a specific purpose (for example, commissioning) can be selected if the quantity of motion is high.

Another option to select a frame consists in selecting a frame depending upon a position of the device deduced from signals from the one or more sensors 530. For example, if one of the sensors is a press button that extrudes from the back of the device only when it is depressed, such button will be automatically pressed if the device is set on a wall or door, and depressed otherwise. Upon energy harvesting, the button can be activated. The signals generated by the button therefore indicate whether the button is pressed or depressed, and thus whether the device is set on a wall or door, or not. Thus, a data frame representative of "daily use" (for example, switching ON/OFF a light) can be selected if the button is pressed (and thus the device set on a wall or door), and a data frame for a specific purpose (for example, commissioning) can be selected otherwise.

Once a data frame is selected, the device 500 is further configured to activate the communication capability 520 to send the selected data frame 542 to the at least one further device 550, 551.

The device 500 uses energy that is harvested when needed. Therefore, the user does not need to worry about the energy usage of the device, or check if the device is charged.

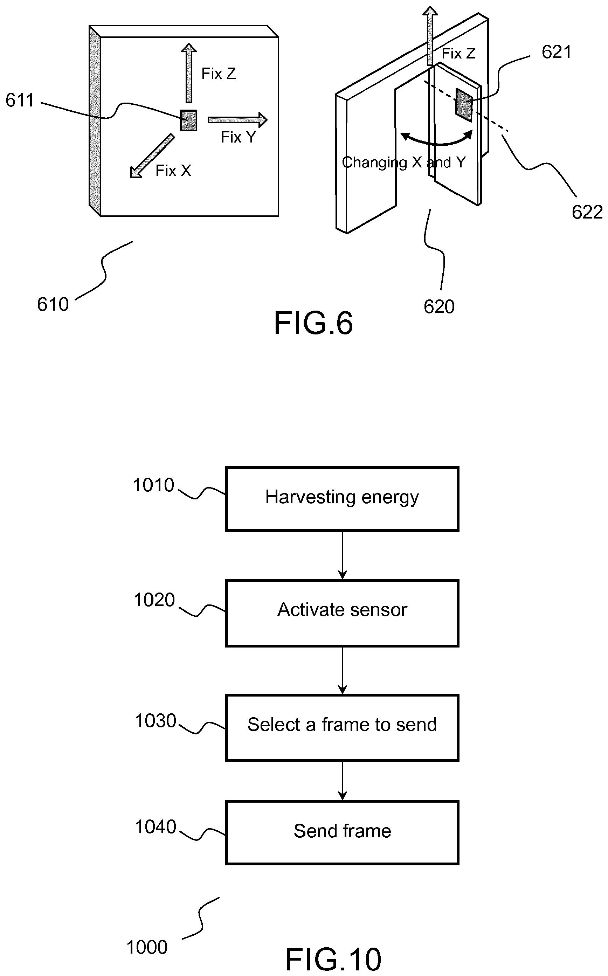

Figure 6 displays two mechanical constraints allowing a selection of a frame to be sent by a device according to the invention.

As noted above, in a number of cases, when using a remote control (for example a remote light switch), a user wishes to commission a network once, then set the switch on a wall or a door. It is therefore desirable, when the user presses a button on the remote control, to detect if the remote control is set or not, in order to send either a commissioning data frame, or data frame to perform remote control (for example switching ON/OFF a light).

A first mechanical constraint 610 consists in setting a device 611 (which may be for example the device 500) on a wall. Thus the device 611 can hardly move. This constraint can be detected, as noted above, by calculating an orientation of the device each time a user performs an action on the device (for example, each time the user presses a button), and determining that the device is set, if the difference between two successive orientations is very low. Thus, a frame representative of the ordinary use of the product (for example a frame to switch a light ON/OFF) is selected if the device is set, and a specific frame (for example a frame to commission a network) is selected otherwise. As noted above, the detection of the setting of the device on the wall can be performed by comparing directly successive values of signals representative of the orientation of the device (for example accelerometer signals): if the absolute difference of two successive values of such signals is below a predefined threshold, it can be assumed that the device is set. The detection can also be performed only based on measurements representative of a rotation around an axis in a transverse plan of the device.

A second mechanical constraint 620 consists in setting the device on a door. Thus, when the device is set, it rotates around the vertical axis, but not around transverse axis 622. It is possible to detect that the device is set using the same principle as above. However, only the orientation around vertical axis and/or signals representative of an orientation around vertical axis are taken into account. Thus, it is possible to detect that the device is set on a door, and rotates around a vertical axis, if two successive values of orientation around the vertical axis are very close, even if the orientation of the device around the other axes changed.

As noted above, it is also possible to detect if a device is set on a wall or door, if an additional push button is placed on the back of the device, extrudes from the back of the device only when it is depressed, and is automatically depressed if there is no obstacle to the depression, i.e only if the button is not set on a wall or door. In this example, if the additional push button produces signals indicating that it is pressed, the device is assumed to be set on a wall or door. Otherwise, if the additional push button produces signals indicating that it is depressed, the device is assumed not to be set on a flat surface, for example a wall or door.

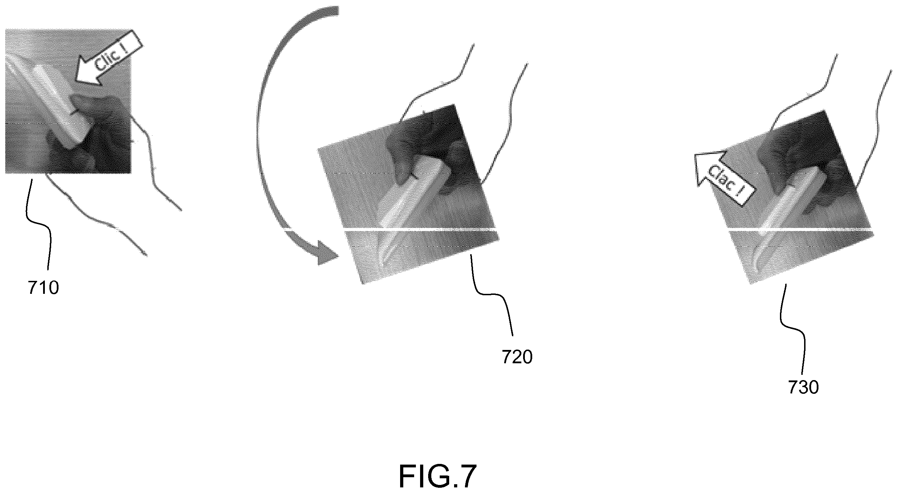

Figure 7 displays an example of selection, in an embodiment of the invention, of a data frame to be sent based on the orientation of the device.

In this example, the device is a remote light switch, wherein a user can press a button either to switch ON/OFF a light, or to commission a network/connect to a light to switch ON/OFF.

The user initially holds the device upwards 710. This position is quite natural: it is the position in which the user naturally holds the remote control. When the user presses the button, a piezoelectric material harvests a small amount of energy. The energy is first used to activate an accelerometer that provides acceleration measurements. Since the user is not imparting a significant movement to the device, the acceleration measurements are mainly composed of gravity components.

The energy amount is further used to activate a processor that calculates, based on the gravity acceleration measurements, a vertical orientation of the device.

Then the user performs a movement of the wrist 720, so that the device is now oriented downwards 730, and the user depresses the button.

Here again, energy is harvested upon depression of the button, the accelerometer is activated to perform measurements representative of gravity components of the acceleration, and the processor is activated to calculate the orientation of the device. The processor further compares the vertical orientation of the device with the vertical orientation of the device stored upon the latest button click. If the orientation is similar between two successive orientations, a first frame intended for the "daily use" of the device (for example, a frame to switch the light ON/OFF) is selected. On the contrary, if there is a significant difference between the orientations, a second frame, which is more specific (for example, a frame to commission a network) is selected.

The determination whether the vertical orientation is similar between two successive button clicks can be performed in different ways. For example, the absolute difference between two successive orientations (or orientation vectors) can be performed: if this difference is below a predefined threshold, a first frame is selected; otherwise, a second frame is selected. Alternatively, a measurement representative of the vertical orientation can be used. For example, acceleration vectors can be used, and the vertical elements of acceleration vectors can be compared between two button clicks.

This therefore provides a very intuitive behavior for the user: when he/she clicks on the button while holding the device in an orientation similar to the previous button click, a frame corresponding to the ordinary purpose of the device is selected and sent; on the contrary, when he/she clicks on the button upon a change of orientation of the device, a specific frame is selected.

Moreover, the frame can be selected and sent nearly instantaneously, and these operations require a very small amount of energy: the accelerometer is activated once for a short duration, and the calculations to calculate an orientation from accelerometer measurements are not complex. Therefore, it is possible to perform these operations with a small amount of energy harvested from a button press.

Other rules of selection of a first or a second frame to be sent are possible. For example, upon the first button click and energy harvesting, the orientation of the device can be stored as a reference orientation. Therefore, upon each button click, the instantaneous orientation of the device is compared to the reference orientation: if the orientation is close to the reference orientation, a first frame representative of the daily use of the device (for example a frame to switch ON/OFF the light) is selected; otherwise, a second frame intended for a specific purpose (for example a frame to commission a network/pair with a light) is selected. Therefore, the user can perform clicks when the device is oriented in the reference orientation, which is the most intuitive for him/her, to send daily use frames, and perform clicks in very different orientations, to send frames intended for specific purposes.

Alternatively, the vertical orientations to select frames may be predefined. For example, an "upwards" orientation can be associated to frames representative of daily use (e.g switching ON/OFF a light), while "downwards" orientation can be associated to specific commands (e.g commissioning a network/pairing with a light). In order to do so, the processor can verify, upon each energy harvesting, if the vertical orientation is higher than a predefined threshold, indicating that the user is holding the device upwards. For example, the predefined threshold can correspond to a horizontal angle.

The processor thus selects a first data frame to be sent. In this example, since the upwards orientation is most natural and comfortable for the user, the first data frame is a "daily use" frame, in this example a frame to switch ON/OFF the light. The vertical orientation of the device is now 730 below the predefined threshold: a second frame is selected. Therefore, the second frame that is selected in this case is a frame intended for specific purpose, such as a frame for commissioning.

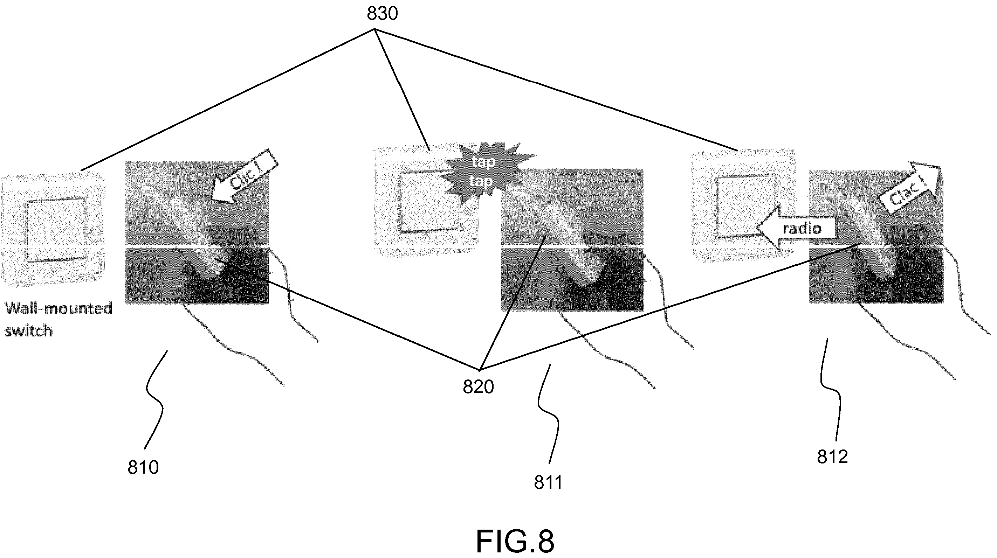

Figure 8 displays an example of selection, in an embodiment of the invention, of a data frame to be sent based on the quantity of motion of the device.

In this example, the device 820 is a remote control to control wall mounted switches, such as the wall mounted switch 830. In this example, the device 820 may perform a commissioning to join a network wherein the wall-mounted switch 830 is present by performing a "tap-tap". The "tap-tap" is a convenient way to commission and join a network developed by the applicant: when a user performs a fast multiple tap (i.e double, triple, quadruple tap, etc...) between a remote control (for example the remote control 820) and a target device (for example the target device 830), a synchronized shock is detected that allows the remote control to join the network of the target device in a very intuitive way. When the user presses the button of the remote control 820, the device thus needs to determine if the user is simply clicking on the button or performing a "tap-tap", and thus if a commissioning frame, or a frame to switch ON/OFF the device is to be sent.

The user first presses the button 810, then performs the "tap-tap" 811, and depresses the button 812. When the user presses the button 810, an amount of energy is harvested. This amount of energy is used to activate one or more motion sensors (for example an accelerometer) during the whole time the button is pressed, and activate the processor to calculate a quantity of movement of the device during the button press. Although the amount of energy required to activate the motion sensors during the whole "tap-tap" is higher than the energy required by other embodiments of the invention such as the example of figure 7, the "tap-tap" is a very short gesture, so the motion sensors can be activated at all time only using the energy harvested by the user pressing the button 810, provided that the motion sensors do not have an excessive energy consumption.

The processor then compares the quantity of motion to a predefined threshold; if the quantity of motion is below the threshold, a first frame to switch ON/OFF is selected and sent, and, otherwise, a frame to perform a commissioning is selected and sent. In this example, the quantity of motion during the button press is high because a "tap-tap" has been performed. Therefore, the device 820 successfully selects a commissioning frame.

Here again, the behavior of the device is very intuitive for the user: if the user simply clicks on the button, without imparting a significant movement to the device, a frame to switch ON/OFF the wall mounted switch is sent, which is the primary purpose of the remote control and its daily operation. Otherwise, if the user performs a "tap-tap", a high quantity of motion is detected, and a commissioning frame is sent.

These examples demonstrate that a device of the invention allows a user to select a frame to be sent very intuitively. However, the invention is not restricted to these examples. Indeed, other kinds of devices can be used, and especially other kinds of remote controls. In addition, other rules or means of selection of a frame to be sent can be used based on signals representative of a position, attitude or motion of a device.

Figures 9a, 9b and 9c display an example of selection, in an embodiment of the invention, of a data frame based on a button on the back of the device, indicating if the device is placed on a flat surface or is in free space.

The figure 9a displays an example of a device 900 that has an extruding button 910a on its back, and an input interface on its front. In the example of figures 9a to 9c, the input interface is a push button 920. However, any input interface (touch surface, plurality of buttons...) may be used.

The figure 9b displays the device 900 in free space. In free space, the extrucing button 910b is not pressed.

The figure 9c displays the device 900 when it is placed on a flat surface. In this example, the device is placed on a wall 940c, but the same effect will be obtained, for example of the device is placed on a door. When the device 900 is placed on a flat surface, the extruding button is automatically pushed 910c.

Thus, the device is able, depending on the state of the extruding button 910a, 910b, 910c, to determine if the device 900 is on a flat surface or in free space. The size, shape and position of the extruding button 910a can be designed in order that it is not pushed when the user is holding the device 900 in hand. Thus, the device is able to determine, based on the state of the extruding button 910a, 910b, 910c, if the user is holding the device in free space, or if it has placed the device on a flat surface.

This information can be used to determine a data frame to send upon an input of the user. For example, when the user presses the button 920, energy is harvested to retrieve the state of the button 910a, 910b, 910c. If the button is depressed 910b, the device is deemed to be held in free space by the user, and a first data frame, for example a commissioning frame, can be sent. If the button is pressed 910c, the device is deemed to be on a flat surface, and a second data frame, for example a frame to send a command to a device the device 900 is now bound to, can be sent.

This allows a number of applications, and a very intuitive behavior for a user. For example, the device 900 can be remote light switch. When the user holds the device in hand, and presses the button 920, a commissioning frame can be sent, in order for the device 900 to pair with a nearby lighting device. When the user puts the device on a wall or a door, and presses again the button 920, the light of the lighting device is switched ON or OFF. Therefore, this allows a very intuitive pairing and control of devices, without the user having to worry about complex combinations of buttons.

The device of figures 9a, 9b and 9c is provided by means of example only of a remote control that determines a data frame to send based on the state of a button that extrudes from the back of the device. According to various embodiments of the invention, this may apply to other kinds of data frames to be sent to other kinds of products, and other kinds of user inputs.

Figure 10 displays a method in a number of embodiments of the invention.

The method 1000 is a method to harvest energy, select and send a data frame.

The method 1000 comprises a first step of harvesting 1010 one or more energy amounts onboard a device, upon one or more actions of a user.

The method 1000 then comprises a second step of using said one or more energy amounts to activate 1020 one or more sensors of the device, to produce signals representative of the position, attitude or motion of the device.

The method 1000 then comprises a third step of using said one or more energy amounts to activate 1030 a digital circuitry of the device to select based at least on said signals a data frame to be sent among a set of possible data frames.

The method 1000 then comprises a fourth step of using said one or more energy amounts to activate 1040 a communication capability of the device to send said data frame to at least one further device.

All the embodiments discussed above are respectively applicable to the method 1000.

The examples described above are given as illustrations of embodiments of the invention. They do not in any way limit the scope of the invention which is defined by the following claims.

## Claims

1. A device (500) comprising:
- an energy harvester (510) adapted to harvest energy upon one or more actions of a user;
- a communication capability (520) adapted to communicate with at least one further device (550, 551);
- one or more sensors (530);
- a digital circuitry (540);
said device being configured, when one or more energy amounts (511) are harvested upon one or more actions of the user, to use said one or more energy amounts (511) to:
- activate the one or more sensors (530), to produce signals representative of the position, attitude or motion of the device;
- activate the digital circuitry (540) to compare at least said signals representative of the position, attitude or motion of the device with a stored signal on the device and to select based on the comparison result, a data frame to be sent (542) among a set of possible data frames (543), said set of data frames comprising at least one first data frame to associate the device to the further device, and at least one second data frame which is a command to be sent to said at least one further device; and
- activate said communication capability (520) to send said data frame to said at least one further device (550, 551).

2. The device of claim 1, wherein the energy harvester is adapted to harvest energy from an action of the user.

3. The device of claim 2, comprising a button, wherein the energy harvester is activated each time the user presses or depresses the button.

4. The device of claim 3, wherein the device is a remote control, and the possible data frames are commands to be sent to said at least one further device.

5. The device of claim 3, wherein the device is a portable light switch, and the button is a light switch button having two positions.

6. The device of claim 5, wherein:
- said at least one further device (550, 551) comprises two or more light switches;
- the set of possible data frames comprises a frame to associate the portable light switch with a set light switch, a frame to instruct a set light switch with which the portable light switch is associated to switch ON the light, and a frame to instruct a set light switch with which the portable light switch is associated to switch OFF the light.

7. The device of one of claims 1 to 6, wherein said one or more sensors comprise one or more attitude or motion sensors.

8. The device of claim 7, wherein the device is configured to use said one or more energy amounts to activate said one or more attitude or motion sensors (530) to obtain signals representative of an instantaneous attitude of the device.

9. The device of claim 8, wherein:
- when the user presses or depresses the button, the device is configured to use said one or more energy amounts to:
o activate the one or more attitude or motion sensors (530), in order to produce signals representative of an instantaneous value of an attitude parameter of the device;
o activate the digital circuitry to select the data frame to be sent from one of:
▪ a comparison of the current value and a latest stored value of said attitude parameter of the device;
▪ or a comparison between said signals and latest stored signals representative of said instantaneous value of the attitude parameter;
o send said data frame;
o store said current value of the attitude parameter of the device, to be used as the latest stored value of said attitude parameter, or store said signals, to be used as the latest stored signals.

10. The device of claim 9 wherein:
- said one or more attitude or motion sensors comprise an accelerometer, and said signals are accelerometer signals;
- said attitude parameter is an orientation of the device;
- the digital circuitry is configured to select a first data frame when:
o an absolute value of a difference between the instantaneous and latest stored values of orientation of the device, or
o an absolute value of a difference between the signals and latest stored values of the signals representative of said instantaneous value of the attitude parameter;
o is below a predefined threshold;
- the digital circuitry is configured to select a second data frame otherwise.

11. The device of claim 10, wherein the orientation is an orientation of an axis in a transverse plan of the device.

12. The device of claim 8, wherein:
- said attitude parameter is an orientation of the device;
- the digital circuitry is configured to select the first data frame when the instantaneous value of the orientation belongs to a set of orientations, and the second data frame otherwise.

13. The device of claim 7, when depending upon claim 3, wherein:
- when the user presses or depresses the button a first time, the energy harvester harvests a first energy amount to:
o activate the one or more attitude or motion sensors (530), in order to produce signals representative of a quantity of motion of the device until the user presses or depresses the button a second time;
- when the user presses or depresses the button the second time, the energy harvester harvests a second energy amount to:
o activate the digital circuitry to select the data frame to be sent from said quantity of motion of the device;
o send said data frame.

14. A method (1000) comprising:
- harvesting (1010) one or more energy amounts onboard a device, upon one or more actions of a user;
- using said one or more energy amounts to:
o activate (1020) one or more sensors of the device, to produce signals representative of the position, attitude or motion of the device;
o activate (1030) a digital circuitry of the device to compare at least said signals representative of the position, attitude or motion of the device with a stored signal on the device and to select based on the comparison result, a data frame to be sent among a set of possible data frames, said set of data frames comprising at least one first data frame to associate the device to at least one further device, and at least one second data frame which is a command to be sent to said at least one further device;
o activate (1040) a communication capability of the device to send said data frame to said at least one further device.

15. A computer program product comprising:
a non-transitory computer-readable storage medium onboard a device; and
program code stored on the non-transitory computer-readable storage medium that, when executed by one or more processors onboard the device using one or more energy amounts harvested onboard the device upon one or more actions of a user, causes the one or more processors to:
- use said one or more energy amounts to:
o activate one or more sensors of the device, to produce signals representative of the position, attitude or motion of the device;
o activate a digital circuitry of the device to compare at least said signals representative of the position, attitude or motion of the device with a stored signal on the device and to select based on the comparison result, a data frame to be sent among a set of possible data frames, said set of data frames comprising at least one first data frame to associate the device to at least one further device, and at least one second data frame which is a command to be sent to said at least one further device;
o activate a communication capability of the device to send said data frame to said at least one further device.

## Patentansprüche

1. Vorrichtung (500), umfassend:
- eine Energiegewinnungsvorrichtung (510), die so ausgelegt ist, dass sie bei einer oder mehreren Aktionen eines Benutzers Energie gewinnt;
- eine Kommunikationsfähigkeit (520), die zur Kommunikation mit mindestens einer weiteren Vorrichtung (550, 551) geeignet ist;
- einen oder mehrere Sensoren (530);
- eine digitale Schaltung (540);
die Vorrichtung so konfiguriert ist, dass sie, wenn eine oder mehrere Energiemengen (511) bei einer oder mehreren Aktionen des Benutzers gewonnen werden, diese eine oder mehrere Energiemengen (511) verwendet, zum:
- Aktivieren des einen oder der mehreren Sensoren (530), um Signale zu erzeugen, die die Position, die Lage oder die Bewegung der Vorrichtung repräsentieren;
- Aktivieren der digitalen Schaltung (540), um mindestens die Signale, die die Position, Lage oder Bewegung der Vorrichtung repräsentieren, mit einem auf der Vorrichtung gespeicherten Signal zu vergleichen und basierend auf dem Vergleichsergebnis einen zu sendenden Datenrahmen (542) aus einer Menge möglicher Datenrahmen (543) auszuwählen, wobei diese Menge von Datenrahmen mindestens einen ersten Datenrahmen zur Zuordnung der Vorrichtung zu der weiteren Vorrichtung und mindestens einen zweiten Datenrahmen umfasst, der ein an die mindestens eine weitere Vorrichtung zu sendender Befehl ist; und
- Aktivieren der Kommunikationsfähigkeit (520), um den Datenrahmen an die mindestens eine weitere Vorrichtung (550, 551) zu senden.

2. Vorrichtung nach Anspruch 1, wobei die Energiegewinnungsvorrichtung so ausgelegt ist, dass sie Energie aus einer Aktion des Benutzers gewinnt.

3. Vorrichtung nach Anspruch 2, umfassend eine Taste, wobei die Energiegewinnungsvorrichtung jedes Mal aktiviert wird, wenn der Benutzer die Taste drückt oder niederdrückt.

4. Vorrichtung nach Anspruch 3, wobei es sich bei der Vorrichtung um eine Fernbedienung handelt und die möglichen Datenrahmen Befehle sind, die an die mindestens eine weitere Vorrichtung gesendet werden sollen.

5. Vorrichtung nach Anspruch 3, wobei es sich bei der Vorrichtung um einen tragbaren Lichtschalter handelt und die Taste eine Lichtschaltertaste mit zwei Positionen ist.

6. Vorrichtung nach Anspruch 5, wobei:
- die mindestens eine weitere Vorrichtung (550, 551) zwei oder mehr Lichtschalter umfasst;
- die Menge der möglichen Datenrahmen einen Rahmen zur Zuordnung des tragbaren Lichtschalters zu einem fest installierten Lichtschalter, einen Rahmen zur Anweisung an einen fest installierten Lichtschalter, dem der tragbare Lichtschalter zugeordnet ist, das Licht EIN zu schalten, und einen Rahmen zur Anweisung an einen fest installierten Lichtschalter, dem der tragbare Lichtschalter zugeordnet ist, das Licht AUS zu schalten.

7. Vorrichtung nach einem der Ansprüche 1 bis 6, wobei der eine oder die mehreren Sensoren einen oder mehrere Lage- oder Bewegungssensoren umfassen.

8. Vorrichtung nach Anspruch 7, wobei die Vorrichtung so konfiguriert ist, dass sie die eine oder mehrere Energiemengen nutzt, um den einen oder die mehreren Lage- oder Bewegungssensoren (530) zu aktivieren, um Signale zu erhalten, die eine momentane Lage der Vorrichtung repräsentieren.

9. Vorrichtung nach Anspruch 8, wobei:
- wenn der Benutzer die Taste drückt oder niederdrückt, die Vorrichtung so konfiguriert ist, dass sie die eine oder mehreren Energiemengen verwendet, zum:
- Aktivieren des einen oder der mehreren Lage- oder Bewegungssensoren (530), um Signale zu erzeugen, die einen momentanen Wert eines Lagenparameters der Vorrichtung repräsentieren;
- Aktivieren der digitalen Schaltung, um den zu sendenden Datenrahmen aus einem der folgenden auszuwählen:
- einem Vergleich des aktuellen Werts mit einem zuletzt gespeicherten Wert des Lageparameters der Vorrichtung;
- oder einem Vergleich zwischen den Signalen und zuletzt gespeicherten Signalen, die den momentanen Wert des Lagenparameters repräsentieren;
- Senden des Datenrahmens;
- Speichern des aktuellen Werts des Lagenparameters der Vorrichtung, der als zuletzt gespeicherter Wert des Lagenparameters verwendet werden soll, oder Speichern der Signale, die als zuletzt gespeicherte Signale verwendet werden sollen.

10. Vorrichtung nach Anspruch 9, wobei:
- der eine oder die mehreren Lage- oder Bewegungssensoren einen Beschleunigungsmesser umfassen und es sich bei den Signalen um Beschleunigungsmessersignale handelt;
- der Lagenparameter eine Orientierung der Vorrichtung ist;
- die digitale Schaltung so konfiguriert ist, dass sie einen ersten Datenrahmen auswählt, wenn:
- ein absoluter Wert einer Differenz zwischen dem momentanen und dem zuletzt gespeicherten Wert der Orientierung der Vorrichtung, oder
- ein absoluter Wert einer Differenz zwischen den Signalen und den zuletzt gespeicherten Signalwerten, die den momentanen Wert des Lagenparameters repräsentieren;
- unterhalb eines vordefinierten Schwellenwerts liegt;
- die digitale Schaltung so konfiguriert ist, dass sie andernfalls einen zweiten Datenrahmen auswählt.

11. Vorrichtung nach Anspruch 10, wobei die Orientierung eine Orientierung einer Achse in einer transversalen Ebene der Vorrichtung ist.

12. Vorrichtung nach Anspruch 8, wobei:
- der Lagenparameter eine Orientierung der Vorrichtung ist;
- die digitale Schaltung so konfiguriert ist, dass sie den ersten Datenrahmen auswählt, wenn der momentane Wert der Orientierung zu einer Menge von Orientierungen gehört, und andernfalls den zweiten Datenrahmen.

13. Vorrichtung nach Anspruch 7, wenn abhängig von Anspruch 3, wobei:
- wenn der Benutzer die Taste zum ersten Mal drückt oder niederdrückt, die Energiegewinnungsvorrichtung eine erste Energiemenge gewinnt, zum:
- Aktivieren des einen oder der mehreren Lage- oder Bewegungssensoren (530), um Signale zu erzeugen, die eine Bewegung der Vorrichtung repräsentieren, bis der Benutzer die Taste ein zweites Mal drückt oder niederdrückt;
- wenn der Benutzer die Taste ein zweites Mal drückt oder niederdrückt, die Energiegewinnungsvorrichtung eine zweite Energiemenge gewinnt, zum:
- Aktivieren der digitalen Schaltung, um den aus der Bewegung der Vorrichtung zu sendenden Datenrahmen auszuwählen;
- Senden des Datenrahmens.

14. Verfahren (1000), umfassend:
- Gewinnen (1010) einer oder mehrerer Energiemengen auf einer Vorrichtung durch eine oder mehrere Aktionen eines Benutzers;
- Verwenden der einen oder mehreren Energiemengen, zum:
- Aktivieren (1020) eines oder mehrerer Sensoren der Vorrichtung, um Signale zu erzeugen, die die Position, die Lage oder die Bewegung der Vorrichtung repräsentieren;
- Aktivieren (1030) einer digitalen Schaltung der Vorrichtung, um mindestens die Signale, die die Position, die Lage oder die Bewegung der Vorrichtung repräsentieren, mit einem auf der Vorrichtung gespeicherten Signal zu vergleichen und auf der Grundlage des Vergleichsergebnisses einen Datenrahmen aus einer Menge möglicher Datenrahmen auszuwählen, der gesendet werden soll, wobei diese Menge von Datenrahmen mindestens einen ersten Datenrahmen zur Zuordnung der Vorrichtung zu mindestens einer weiteren Vorrichtung und mindestens einen zweiten Datenrahmen umfasst, der ein Befehl ist, der an die mindestens eine weitere Vorrichtung gesendet werden soll;
- Aktivieren (1040) einer Kommunikationsfähigkeit der Vorrichtung, um den Datenrahmen an die mindestens eine weitere Vorrichtung zu senden.

15. Computerprogrammprodukt, umfassend:
ein nichtflüchtiges, computerlesbares Speichermedium auf einer Vorrichtung; und
Programmcode, der auf dem nichtflüchtigen, computerlesbaren Speichermedium gespeichert ist und der, wenn er von einem oder mehreren Prozessoren auf der Vorrichtung unter Verwendung einer oder mehrerer auf der Vorrichtung gewonnener Energiemengen bei einer oder mehreren Aktionen eines Benutzers ausgeführt wird, bewirkt, dass der eine oder die mehreren Prozessoren Folgendes ausführen:
- Verwenden der einen oder der mehreren Energiemengen, zum:
- Aktivieren eines oder mehrerer Sensoren der Vorrichtung, um Signale zu erzeugen, die die Position, die Lage oder die Bewegung der Vorrichtung repräsentieren;
- Aktivieren einer digitalen Schaltung der Vorrichtung, um mindestens die Signale, die die Position, die Lage oder die Bewegung der Vorrichtung repräsentieren, mit einem auf der Vorrichtung gespeicherten Signal zu vergleichen und auf der Grundlage des Vergleichsergebnisses einen Datenrahmen aus einer Menge möglicher Datenrahmen auszuwählen, der gesendet werden soll, wobei diese Menge von Datenrahmen mindestens einen ersten Datenrahmen zur Zuordnung der Vorrichtung zu mindestens einer weiteren Vorrichtung und mindestens einen zweiten Datenrahmen umfasst, der ein Befehl ist, der an die mindestens eine weitere Vorrichtung gesendet werden soll;
- Aktivieren einer Kommunikationsfähigkeit der Vorrichtung, um den Datenrahmen an die mindestens eine weitere Vorrichtung zu senden.

## Revendications

1. Dispositif (500) comprenant :
- un collecteur d'énergie (510) adapté pour collecter de l'énergie suite à une ou plusieurs actions d'un utilisateur ;
- une capacité de communication (520) adaptée pour communiquer avec au moins un dispositif supplémentaire (550, 551) ;
- un ou plusieurs capteurs (530) ;
- des circuits numériques (540) ;
ledit dispositif étant configuré, lorsqu'une ou plusieurs quantités d'énergie (511) sont collectées suite à une ou plusieurs actions de l'utilisateur, pour utiliser lesdites une ou plusieurs quantités d'énergie (511) pour :
- activer l'un ou les plusieurs capteurs (530), pour produire des signaux représentatifs de la position, de l'attitude ou du mouvement du dispositif ;
- activer les circuits numériques (540) pour comparer au moins lesdits signaux représentatifs de la position, de l'attitude ou du mouvement du dispositif avec un signal stocké sur le dispositif et pour sélectionner, sur la base du résultat de comparaison, une trame de données à envoyer (542) parmi un ensemble de trames de données possibles (543), ledit ensemble de trames de données comprenant au moins une première trame de données pour associer le dispositif au dispositif supplémentaire, et au moins une seconde trame de données qui est une commande à envoyer audit au moins un dispositif supplémentaire ; et
- activer ladite capacité de communication (520) pour envoyer ladite trame de données à l'au moins un dispositif supplémentaire (550, 551).

2. Dispositif selon la revendication 1, dans lequel le collecteur d'énergie est adapté pour collecter de l'énergie à partir d'une action de l'utilisateur.

3. Dispositif selon la revendication 2, comprenant un bouton, dans lequel le collecteur d'énergie est activé chaque fois que l'utilisateur appuie sur ou enfonce le bouton.

4. Dispositif selon la revendication 3, dans lequel le dispositif est une télécommande, et les trames de données possibles sont des commandes à envoyer audit au moins un dispositif supplémentaire.

5. Dispositif selon la revendication 3, dans lequel le dispositif est un interrupteur de lumière portable, et le bouton est un bouton d'interrupteur de lumière présentant deux positions.

6. Dispositif selon la revendication 5, dans lequel :
- l'au moins un dispositif supplémentaire (550, 551) comprend deux ou plusieurs interrupteurs de lumière ;
- l'ensemble de trames de données possibles comprend une trame pour associer l'interrupteur de lumière portable à un interrupteur de lumière fixe, une trame pour ordonner à un interrupteur de lumière fixe auquel l'interrupteur de lumière portable est associé d'allumer la lumière, et une trame pour ordonner à un interrupteur de lumière fixe auquel l'interrupteur de lumière portable est associé d'éteindre la lumière.

7. Dispositif selon l'une quelconque des revendications 1 à 6, dans lequel lesdits un ou plusieurs capteurs comprennent un ou plusieurs capteurs d'attitude ou de mouvement.

8. Dispositif selon la revendication 7, dans lequel le dispositif est configuré pour utiliser lesdites une ou plusieurs quantités d'énergie pour activer lesdits un ou plusieurs capteurs d'attitude ou de mouvement (530) pour obtenir des signaux représentatifs d'une attitude instantanée du dispositif.

9. Dispositif selon la revendication 8, dans lequel :
- lorsque l'utilisateur appuie sur ou enfonce le bouton, le dispositif est configuré pour utiliser une ou plusieurs quantités d'énergie pour :
- activer l'un ou les plusieurs capteurs d'attitude ou de mouvement (530), afin de produire des signaux représentatifs d'une valeur instantanée d'un paramètre d'attitude du dispositif ;
- activer les circuits numériques pour sélectionner la trame de données à envoyer à partir d'une parmi :
- une comparaison de la valeur actuelle et de la dernière valeur stockée dudit paramètre d'attitude du dispositif ;
- ou une comparaison entre lesdits signaux et les derniers signaux stockés représentatifs de ladite valeur instantanée du paramètre d'attitude ;
- envoyer ladite trame de données ;
- stocker ladite valeur actuelle du paramètre d'attitude du dispositif, à utiliser comme dernière valeur stockée dudit paramètre d'attitude, ou stocker lesdits signaux, à utiliser comme derniers signaux stockés.

10. Dispositif selon la revendication 9, dans lequel :
- lesdits un ou plusieurs capteurs d'attitude ou de mouvement comprennent un accéléromètre, et lesdits signaux sont des signaux d'accéléromètre ;
- ledit paramètre d'attitude est une orientation du dispositif ;
- les circuits numériques sont configurés pour sélectionner une première trame de données lorsque :
- une valeur absolue d'une différence entre les valeurs instantanées et les dernières valeurs stockées de l'orientation du dispositif, ou
- une valeur absolue d'une différence entre les signaux et les dernières valeurs stockées des signaux représentatifs de ladite valeur instantanée du paramètre d'attitude ;
- est inférieure à un seuil prédéfini ;
- les circuits numériques sont configurés pour sélectionner une seconde trame de données autrement.

11. Dispositif selon la revendication 10, dans lequel l'orientation est une orientation d'un axe dans un plan transversal du dispositif.

12. Dispositif selon la revendication 8, dans lequel :
- ledit paramètre d'attitude est une orientation du dispositif ;
- les circuits numériques sont configurés pour sélectionner la première trame de données lorsque la valeur instantanée de l'orientation appartient à un ensemble d'orientations, et autrement la seconde trame de données.

13. Dispositif selon la revendication 7, lorsqu'elle dépend de la revendication 3, dans lequel :
- lorsque l'utilisateur appuie sur ou enfonce le bouton une première fois, le collecteur d'énergie collecte une première quantité d'énergie pour :
- activer l'un ou les plusieurs capteurs d'attitude ou de mouvement (530), afin de produire des signaux représentatifs d'une quantité de mouvement du dispositif jusqu'à ce que l'utilisateur appuie sur ou enfonce le bouton une seconde fois ;
- lorsque l'utilisateur appuie sur ou relâche le bouton la seconde fois, le collecteur d'énergie collecte une seconde quantité d'énergie pour :
- activer les circuits numériques pour sélectionner la trame de données à envoyer à partir de ladite quantité de mouvement du dispositif ;
- envoyer ladite trame de données.

14. Procédé (1000) comprenant :
- la collecte (1010) d'une ou de plusieurs quantités d'énergie à bord d'un dispositif, suite à une ou plusieurs actions d'un utilisateur ;
- l'utilisation desdites une ou plusieurs quantités d'énergie revient à :
- activer (1020) un ou plusieurs capteurs du dispositif, pour produire des signaux représentatifs de la position, de l'attitude ou du mouvement du dispositif ;
- activer (1030) des circuits numériques du dispositif pour comparer au moins lesdits signaux représentatifs de la position, de l'attitude ou du mouvement du dispositif avec un signal stocké sur le dispositif et pour sélectionner, sur la base du résultat de comparaison, une trame de données à envoyer parmi un ensemble de trames de données possibles, ledit ensemble de trames de données comprenant au moins une première trame de données pour associer le dispositif à au moins un dispositif supplémentaire, et au moins une seconde trame de données qui est une commande à envoyer audit au moins un dispositif supplémentaire ;
- activer (1040) une capacité de communication du dispositif pour envoyer ladite trame de données audit au moins un dispositif supplémentaire.

15. Produit de programme informatique comprenant :
un support de stockage non transitoire lisible par ordinateur à bord d'un dispositif ; et
du code de programme stocké sur le support de stockage non transitoire lisible par ordinateur qui, lorsqu'il est exécuté par un ou plusieurs processeurs à bord du dispositif utilisant une ou plusieurs quantités d'énergie collectées à bord du dispositif suite à une ou plusieurs actions d'un utilisateur, amène l'un ou les plusieurs processeurs à :
- utiliser lesdites une ou plusieurs quantités d'énergie pour :
- activer un ou plusieurs capteurs du dispositif, pour produire des signaux représentatifs de la position, de l'attitude ou du mouvement du dispositif ;
- activer des circuits numériques du dispositif pour comparer au moins lesdits signaux représentatifs de la position, de l'attitude ou du mouvement du dispositif avec un signal stocké sur le dispositif et pour sélectionner, sur la base du résultat de comparaison, une trame de données à envoyer parmi un ensemble de trames de données possibles, ledit ensemble de trames de données comprenant au moins une première trame de données pour associer le dispositif à au moins un dispositif supplémentaire, et au moins une seconde trame de données qui est une commande à envoyer audit au moins un dispositif supplémentaire ;
- activer une capacité de communication du dispositif pour envoyer ladite trame de données à l'au moins un dispositif supplémentaire.
